Europäisches Patentamt

European Patent Office

Office européen des brevets

(19)

(11) **EP 0 692 878 A2**

(12) **EUROPÄISCHE PATENTANMELDUNG**

(43) Veröffentlichungstag:
17.01.1996 Patentblatt 1996/03

(51) Int. Cl.6: **H03L 7/099**

(21) Anmeldenummer: 95201881.0

(22) Anmeldetag: 10.07.1995

(84) Benannte Vertragsstaaten:
DE FR GB

(30) Priorität: 15.07.1994 DE 4425087

(71) Anmelder:
• Philips Patentverwaltung GmbH
D-22335 Hamburg (DE)
Benannte Vertragsstaaten:
DE
• PHILIPS ELECTRONICS N.V.
NL-5621 BA Eindhoven (NL)
Benannte Vertragsstaaten:
FR GB

(72) Erfinder:
• Götz, Hans-Joachim, Dr.-Ing.
D-22335 Hamburg (DE)
• Brachmann, Markus, Dipl.-Ing.
D-22335 Hamburg (DE)
• Frank, Georg, Dr. rer. nat.
D-22335 Hamburg (DE)
• Eckhart, Thomas
D-22335 Hamburg (DE)

(74) Vertreter: Volmer, Georg, Dipl.-Ing. et al
D-22335 Hamburg (DE)

(54) **Übertragungssystem**

(57) Die Erfindung bezieht sich auf ein Übertragungssystem mit einem Phasenregelkreis (12), der einen Phasenvergleicher (15) zum Vergleich eines Oszillatorsignals mit einem Referenzsignal und zur Erzeugung eines Vergleichssignals und einen Oszillator enthält, der zum Empfang eines aus dem Vergleichssignal abgeleiteten Steuersignals vorgesehen ist. Der als Ringoszillator (14) ausgebildete Oszillator enthält wenigstens ein in einem Ring geschaltetes Verzögerungsglied (27 bis 31). Wenigstens ein Verzögerungsglied (27 bis 30) weist wenigstens zwei unterschiedliche einstellbare Verzögerungszeiten auf. Eine Steueranordnung (19) ist in Abhängigkeit vom Vergleichssignal zur Einstellung der Verzögerungszeiten von wenigstens einem Verzögerungsglied (27 bis 30) vorgesehen.

FIG. 3

EP 0 692 878 A2

**Beschreibung**

Die Erfindung bezieht sich auf ein Übertragungssystem mit einem Phasenregelkreis, der

- einen Phasenvergleicher zum Vergleich eines Oszillatorsignals mit einem Referenzsignal und zur Erzeugung eines Vergleichssignals und
- einen Oszillator enthält, der zum Empfang eines aus dem Vergleichssignal abgeleiteten Steuersignals vorgesehen ist.

Aus der EP-0 404 268 A2 ist ein solches Übertragungssystem bekannt, bei dem Daten eines ankommenden Signals in einen Pufferspeicher eingeschrieben werden. Die aus dem Pufferspeicher ausgelesenen Daten bilden ein abgehendes Signal. Für den Einschreibvorgang von Daten in den Pufferspeicher liefert ein Schreibadressengenerator (z.B. Zähler) Schreibadressen. Dem Schreibadressengenerator wird hierzu noch ein aus dem ankommenden Signal abgeleitetes Schreibtaktsignal zugeführt. Den Auslesevorgang steuert ein Leseadressen bildender Leseadressengenerator (z.B. Zähler), der ein Lesetaktsignal erhält. Mittels des Übertragungssystems werden Stopf- und Steuerdaten, die im ankommenden Signal vorhanden sind, nicht im abgehenden Signal weitergeleitet. Hierbei wird eine Differenzbildung der Schreib- und Leseadressen durchgeführt, aus dem ein Referenzsignal für einem Phasenregelkreis gebildet wird. Der Phasenregelkreis, der einen Phasenvergleicher und einen Oszillator enthält, bildet das Lesetaktsignal in Abhängigkeit von dem im Phasenvergleicher durchgeführten Vergleich zwischen Referenzsignal und Oszillatorsignal, aus dem das Lesetaktsignal abgeleitet wird.

Der in dem Übertragungssystem verwendete Phasenregelkreis verwendet noch Komponenten, bei denen eine Integration in der Technik, in der die anderen Komponenten des Übertragungssystems realisiert sind, nicht möglich ist. Der Phasenregelkreis enthält Komponenten in ECL-Technik und weitere diskrete Bauelemente, während die anderen Komponenten des Übertragungssystems in CMOS-Technik in wenigstens einer integrierten Schaltung integriert sind.

Der Erfindung liegt daher die Aufgabe zugrunde, ein Übertragungssystem der eingangs genannten Art zu schaffen, bei der die wesentlichen Komponenten des Phasenregelkreises in der gleichen Technik realisiert werden wie die übrigen Komponenten des Übertragungssystems.

Die Aufgabe wird durch ein Übertragungssystem der eingangs genannten Art dadurch gelöst,

daß der als Ringoszillator ausgebildete Oszillator wenigstens ein in einem Ring geschaltetes Verzögerungsglied enthält, daß wenigstens ein Verzögerungsglied wenigstens zwei unterschiedliche einstellbare Verzögerungszeiten aufweist und daß eine Steueranordnung in Abhängigkeit vom Vergleichssignal zur Einstellung der Verzögerungszeiten von wenigstens einem Verzögerungsglied vorgesehen ist.

Das erfindungsgemäße Übertragungssystem enthält einen Phasenregelkreis mit einem Ringoszillator, der in einem Ring geschaltete Verzögerungsglieder enthält. Dieser Ringoszillator muß mindestens ein einstellbares Verzögerungsglied, dessen Eingang und dessen Ausgang verbunden sind, enthalten. Die Frequenz und Phase des von dem Ringoszillator erzeugten Oszillatorsignals ist durch Wechsel der verschiedenen Verzögerungszeiten des Ringoszillators einstellbar. Ein solches Verzögerungsglied kann mehr als zwei unterschiedliche Verzögerungszeiten aufweisen. Um eine einfachere Steuerung des Ringoszillators durchzuführen, sollten mehrere Verzögerungsglieder mit zwei unterschiedlichen jeweils ungefähr gleichen Verzögerungszeiten zu dem Ring zusammengeschaltet sein. Hierbei müssen nicht alle Verzögerungsglieder einstellbar sein. Eine Steueranordnung empfängt ein Signal, welches aus dem von dem Phasenvergleicher gebildeten Vergleichssignal abgeleitet ist, und bildet ein Steuersignal zur Einstellung der Verzögerungszeiten der einstellbaren Verzögerungsglieder. Diese Komponenten des Phasenregelkreises können in CMOS-Technik realisiert werden, wodurch der Herstellungsprozeß des Übertragungssystems vereinfacht wird.

Eine einfache Ausführungsform der Steueranordnung zur Einstellung der Verzögerungszeit der in dem Ringoszillator enthaltenen Verzögerungsglieder enthält ein Schieberegister mit Schiebeelementen. Die Anzahl der Schiebeelemente, welche jeweils zur Einstellung der Verzögerungszeit eines zugeordneten Verzögerungsgliedes vorgesehen ist, entspricht der Anzahl der einstellbaren Verzögerungsglieder. In Abhängigkeit vom Vergleichssignal ist eine erste Gruppe von Schiebeelementen zur Einstellung einer ersten und/oder wenigstens eine zweite Gruppe von Schiebeelementen zur Einstellung einer zweiten Verzögerungszeit vorgesehen. Enthalten die Verzögerungsglieder jeweils nur zwei einstellbare Verzögerungszeiten so treten zwei Gruppen von Verzögerungsgliedern auf. Bei einer Veränderung des Vergleichssignals verändert sich auch das Verhältnis der Anzahl der Verzögerungsglieder der ersten und zweiten Gruppe. Bei extremen Verhältnissen können alle Verzögerungsglieder einer Gruppe zugeordnet sein.

Ein Schiebeelement enthält ein erstes Kippglied und ein vor dem Eingang des ersten Kippgliedes angeordneten, in Abhängigkeit vom Vergleichssignal gesteuerten, ersten Umschalter mit einem ersten und zweiten Eingang. Der erste und zweite Eingang eines ersten Umschalters eines Schiebeelementes stellen den ersten und zweiten Eingang des Schiebeelementes und der Ausgang des ersten Kippgliedes des Schiebeelementes den Ausgang des Schiebeelementes dar. Die Einstellung der Schiebeelemente erfolgt durch Verschieben einer logischen "1" (erster Zustand) und einer logischen "0" (zweiter Zustand) im Schieberegister. Ein erstes Schiebeelement weist an seinem ersten Eingang einen ersten Zustand und ein letztes Schiebeelement an seinem zweiten Eingang einen zweiten Zustand auf. Jeweils der Ausgang der anderen zwischen dem ersten und letzten Schiebeelement angeordneten Schiebeelemente ist mit dem ersten Eingang des einen benachbarten und mit dem zweiten Eingang des anderen benachbarten Schiebeelementes gekoppelt.

Ein einstellbares Verzögerungsglied des Ringoszillators enthält einen zweiten Umschalter, der gesteuert von der Steueranordnung zur Kopplung des Eingangs des Verzögerungsgliedes mit dessen Ausgang über wenigstens zwei unterschiedliche Laufzeitwege vorgesehen ist. In einem Laufzeitweg mit der kleineren Verzögerungszeit ist beispielsweise kein weiteres Bauelement vorhanden. Der Laufzeitweg mit der größeren Verzögerungszeit kann beispielsweise zwei in Reihe geschaltete Inverter enthalten.

Ein Laufzeitweg kann auch wenigstens einen Inverter enthalten, dessen Laufzeit über die Ausgangsbelastung einstellbar ist. Die Ausgangsbelastung wird durch Ankopplung eines oder mehrerer zusätzlicher Gatter (Inverter) am Ausgang des im Laufzeitweg liegenden Inverters realisiert. Eine Ausgangsbelastung kann durch einen oder mehrere Inverter, Kapazitäten, zusätzliche Leitungen usw. realisiert werden. Wenn zwei unterschiedliche Laufzeitwege zwei Inverter mit unterschiedlicher Ausgangsbelastung enthalten, kann die Verzögerungszeit in noch kleineren Schritten eingestellt werden, da sich die durch die Ausgangsbelastung ergebende Verzögerungszeit um einen Bruchteil einer Verzögerungszeit des Gatters erhöht.

Um zu verhindern, daß der zweite Umschalter in dem Moment umschaltet, wenn ein Flankenwechsel des das einstellbare Verzögerungsglied und den Ringoszillator durchlaufenden Signals stattfindet, ist eine Synchronisationsschaltung vorgesehen. Hierbei ist der zweite Umschalter des einstellbaren Verzögerungsgliedes zum Empfang eines über die Synchronisationsschaltung eines Verzögerungsgliedes zugeführten Umschaltsignals von dem ersten Umschalter des zugeordneten Schiebeelementes vorgesehen. Die Synchronisationsschaltung ist also zur Synchronisation des Umschaltsignals mit dem Ausgangssignal des Verzögerungsgliedes vorgesehen. Durch diese Maßnahme werden Störimpulse bei der Umschaltung vermieden.

In einer einfach zu relisierenden Ausführungsform des Phasenvergleichers enthält dieser eine Zähleranordnung und eine Kombinationsschaltung. Die Zähleranordnung ist zur Zählung der Taktzyklen des Oszillatorsignals während eines Taktzyklus eines Referenztaktsignals und die Kombinationsschaltung ist zur Erzeugung des Vergleichssignals durch Kombination des Zählergebnisses und dem Sollphasenwert vorgesehen. Es ist auch möglich als Zählergebnis die Anzahl der Takte des Referenztaktsignales während eines Taktzyklus des Oszillatorsignals zu verwenden. Hierbei sollte die Frequenz des Referenztaktsignals größer als die Frequenz des Oszillatorsignals sein.

Der Phasenregelkreis im Übertragungssystem dient zur Reduzierung des Jitters im abgehenden Signal. Um eine weitere Jitterreduzierung zu erreichen, enthält der Phasenvergleicher noch Kippgliedanordnungen und eine Auswerteschaltung. Jeweils jedem Verzögerungsglied zugeordnete Kippgliedanordnungen sind zur Speicherung des Ausgangszustandes des jeweiligen Verzögerungsgliedes zu von dem Referenztaktsignal gegebenen Referenzzeitpunkten vorgesehen. Die Auswerteschaltung dient zur Ermittlung eines Phasenwertes zu einem Referenzzeitpunkt anhand der gespeicherten Ausgangszustände der Verzögerungsglieder und der eingestellten Verzögerungszeiten der Verzögerungsglieder. Die Kombinationsschaltung ist weiter zur Kombination des Phasenwertes mit dem Sollphasenwert und dem Zählergebnis vorgesehen.

Eine Kippgliedanordnung kann aus einem EXKLUSIV-ODER-Gatter, einem Kippglied und einer Detektionsschaltung bestehen. Die Ausgangszustände von zwei aufeinanderfolgenden Verzögerungsgliedern werden jeweils in einem EXKLUSIV-ODER-Gatter verknüpft und der Ausgangszustand des EXKLUSIV-ODER-Gatters in dem Kippglied gespeichert. Die Detektionsschaltung dient zur Detektierung, ob ein nieder- oder höherwertiger Zustand im Kippglied gespeichert ist. In einer anderen Ausführungsform einer Kippgliedanordnung ist ein zweites Kippglied zur Speicherung eines höherwertigen Ausgangszustandes und ein drittes Kippglied zur Speicherung eines niederwertigen Ausgangszustandes des zugeordneten Verzögerungsgliedes bestimmt.

Wenn der Ringoszillator eine gerade Anzahl von einstellbaren Verzögerungsgliedern enthält, ist noch ein Inverter im Ring als nicht einstellbares Verzögerungsglied vorhanden.

Die Berechnung des Phasenwertes wird in der Auswerteschaltung nach den folgenden Formeln berechnet: Der Phasenwert $\Phi$ beträgt:

$$\Phi = 2\Pi \frac{x\ T_V}{2\ [N\ T_V + (N - n)\ \Delta T + T_i]} = \Phi_{P1}\ ,$$

wenn die Anzahl x der den höherwertigen Ausgangszustand speichernden Kippgliedanordnungen kleiner oder gleich der Anzahl n der auf eine erste, kleiner als die zweite andauernde Verzögerungszeit eingestellten Verzögerungsglieder ist,

$$\Phi = \Phi_{P1} + \Pi,$$

wenn die Anzahl x der den niederwertigen Ausgangszustand speichernden Kippgliedanordnungen kleiner oder gleich der Anzahl n der auf eine erste Verzögerungszeit eingestellten Verzögerungsglieder ist,

$$\Phi = 2\Pi \frac{n\ T_V + (x - n)\ \Delta T}{2\ [N\ T_V + (N - n)\ \Delta T + T_i]} = \Phi_{P2},$$

wenn die Anzahl x der den höherwertigen Ausgangszustand speichernden Kippgliedanordnungen größer als die Anzahl n der auf eine erste Verzögerungszeit eingestellten Verzögerungsglieder ist, und

$$\Phi = \Phi_{P2} + \Pi,$$

wenn die Anzahl x der den niederwertigen Ausgangszustand speichernden Kippgliedanordnungen größer als die Anzahl n der auf eine erste Verzögerungszeit eingestellten Verzögerungsglieder ist. N ist dabei die Gesamtzahl der Verzögerungsglieder, $T_V$ die erste Verzögerungszeit, $T_V + \Delta T$ die zweite Verzögerungszeit und $T_i$ die Verzögerungszeit des als Inverter ausgebildeten Verzögerungsgliedes.

Zwischen Phasenvergleicher und Steueranordnung ist ein Sigma-Delta-Modulator zur Erzeugung eines Ausgangssignals angeordnet, welches drei unterschiedliche Zustände aufweisen kann. Die drei Zustände bedeuten, daß bei einem höherwertigen Zustand eines aus dem Ausgangssignals des Sigma-Delta-Modulators abgeleitetes Signal ein erstes, in einem ersten Zustand befindliches Kippglied zum Wechsel in einen zweiten Zustand, bei einem niederwertigen Zustand des Signals ein erstes, in einem zweiten Zustand befindliches Kippglied zum Wechsel in einen ersten Zustand und bei einem mittleren Zustand des Signals kein erstes Kippglied zur Änderung seines Zustandes vorgesehen ist. Im Schieberegister wird bei dem niederwertigen und dem höherwertigen Zustand jeweils der Ausgangszustand eines Kippgliedes eines Schiebeelementes verändert. Im anderen Fall ändert sich nicht der Zustand des Schieberegisters.

Das Übertragungssystem dient insbesondere zur Entnahme von Stopf- und Steuerdaten aus einem Signal. Hierbei ist ein Pufferspeicher zur Zwischenspeicherung von Daten eines ersten Signals mit einer ersten Bitrate und zur Bildung eines zweiten Signals mit einer zweiten Bitrate, ein Schreibadressengenerator zum Empfang eines aus dem ersten Signal abgeleiteten Schreibtaktsignals und zur Lieferung von Schreibadressen, ein Leseadressengenerator zum Empfang eines aus dem Oszillatorsignal des Phasenregelkreises abgeleiteten Lesetaktsignals und zur Lieferung von Leseadressen, ein Subtrahierer zur Subtraktion der von dem Lese- und Schreibadressengenerator gebildeten Lese- und Schreibadressen und zur Lieferung eines Differenzsignals und der Phasenregelkreis zum Empfang der aus dem Differenzsignal abgeleiteten Sollphasenwerte vorgesehen.

Die Erfindung bezieht sich auch auf einen Phasenregelkreis mit einen Phasenvergleicher zum Vergleich eines Oszillatorsignals mit einem Referenzsignal und zur Erzeugung eines Vergleichssignals und einen Oszillator, der zum Empfang eines aus dem Vergleichssignal abgeleiteten Steuersignals vorgesehen ist. Der als Ringoszillator ausgebildete Oszillator enthält wenigstens ein in einem Ring geschaltetes Verzögerungsglied. Wenigstens ein Verzögerungsglied weist wenigstens zwei unterschiedliche einstellbare Verzögerungszeiten auf. Eine Steueranordnung ist in Abhängigkeit vom Vergleichssignal zur Einstellung der Verzögerungszeiten von wenigstens einem Verzögerungsglied vorgesehen ist.

Ausführungsbeispiele der Erfindung werden nachstehend anhand der Zeichnungen näher erläutert. Es zeigen:

Fig. 1    ein Übertragungssystem mit einem Phasenregelkreis,
Fig. 2    ein schematisch dargestellter in dem Übertragungssystem nach Fig. 1 verwendbarer Phasenregelkreis,
Fig. 3    ein Teil des Phasenregelkreises mir Steueranordnung, Ringoszillator, Kippgliedanordnungen und Auswerteschaltung,
Fig. 4    ein in der Steueranordnung nach Fig. 3 enthaltenes Schiebeelement,
Fig. 5    ein erstes Ausführungsbeispiel für ein in dem Ringoszillator nach Fig. 3 enthaltenes einstellbares Verzögerungsglied und
Fig. 6    ein zweites Ausführungsbeispiel für ein in dem Ringoszillator nach Fig. 3 enthaltenes einstellbares Verzögerungsglied.

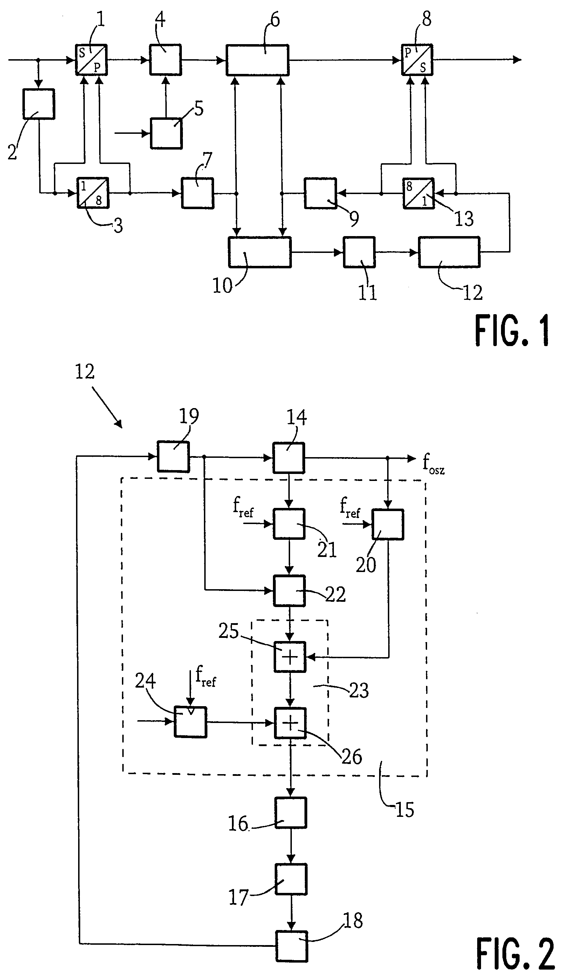

Das in der Fig. 1 dargestellte Ausführungsbeispiel eines Übertragungssystems entfernt aus einem ersten, ankommenden Signal Stopf- und Steuerdaten und bildet ein zweites, abgehendes Signal. Das erste Signal ist beispielsweise ein STM-1-Signal der synchronen digitalen Hierachie und weist eine Bitrate von 155,52 Mbit/s auf. Das zweite Signal ist ein plesiochrones Signal mit einer Bitrate von 139,264 Mbit/s.

In einem Serien-Parallel-Umsetzer 1 wird das serielle, erste Signal in ein paralleles Signal mit Datenblöcken von 8 Bit umgesetzt. Der Serien-Parallel-Umsetzer 1 erhält jeweils ein mittels einer Taktrückgewinnungsschaltung 2 erzeugtes, erstes Taktsignal und ein zweites Taktsignal, welches mittels eines Teilers 3 mit einem Teilerverhältnis von 1:8 aus dem ersten Taktsignal gebildet worden ist. Die Datenblöcke des ersten Signals werden einer Auswahlmatrix 4 zugeführt, die näher in der EP-0 404 268 A2 beschrieben ist und die Stopfdaten und Steuerdaten aus dem ersten Signal entfernt. Gesteuert wird die Auswahlmatrix von einer Steuervorrichtung 5, die zuvor aus dem ersten Signal entnommene Informationen erhält. Dieser Entnahmevorgang ist hier nicht näher dargestellt.

Die von der Auswahlmatrix 5 abgegebenen Datenblöcke werden in einen Pufferspeicher 6 zur Taktanpassung eingeschrieben. Für den Einschreibvorgang werden von einem als Zähler ausgebildeten Schreibadressengenerator 7 Schreibadressen geliefert, der ein Schreibtaktsignal erhält. Das Schreibtaktsignal ist das zweite Taktsignal, welches von dem Teiler 3 gebildet wird. Die aus dem Pufferspeicher 6 ausgelesenen Datenblöcke werden von einem Parallel-Serien-Umsetzer 8 als serielles, zweites Signal abgegeben. Die Leseadressen für den Auslesevorgang liefert ein Leseadressengenerator 9, der ebenfalls als Zähler ausgebildet ist.

Um den Jitter im abgehenden zweiten Signal gering zu halten, ist ein Hauptregelkreis mit einem Subtrahierer 10, einem Tiefpaßfilter 11, einem Phasenregelkreis 12, einem Teiler 13 und der Leseadressengenerator 9 vorgesehen. In dem Subtrahierer 10 wird die Differenz zwischen Leseadressen und Schreibadressen gebildet und als Differenzsignal dem Tiefpaßfilter 11 geliefert. Der Phasenregelkreis erhält von dem Tiefpaßfilter 11 den Sollphasenwert und erzeugt ein Oszillatorsignal, welches dem Teiler 13 mit einem Teilerverhältnis von 1:8 und dem Parallel-Serien-Umsetzer 8 zugeführt wird. Der Teiler 13 erzeugt ein Lesetaktsignal, das dem Parallel-Serien-Umsetzer 8 und dem Leseadressengenerator 9 zugeleitet wird.

Ein Ausführungsbeispiel für den Phasenregelkreis 12 ist in der Fig. 2 als Blockschaltbild dargestellt. Der Phasenregelkreis 12 enthält einen Ringoszillator 14, einen Phasenvergleicher 15, ein Tiefpaßfilter 16, einen Sigma-Delta-Modulator 17, einen Differenzierer 18 und eine Steueranordnung 19. Der Ringoszillator 14 erzeugt das Oszillatorsignal, welches dem Teiler 13 und dem Phasenvergleicher 15 zugeführt wird.

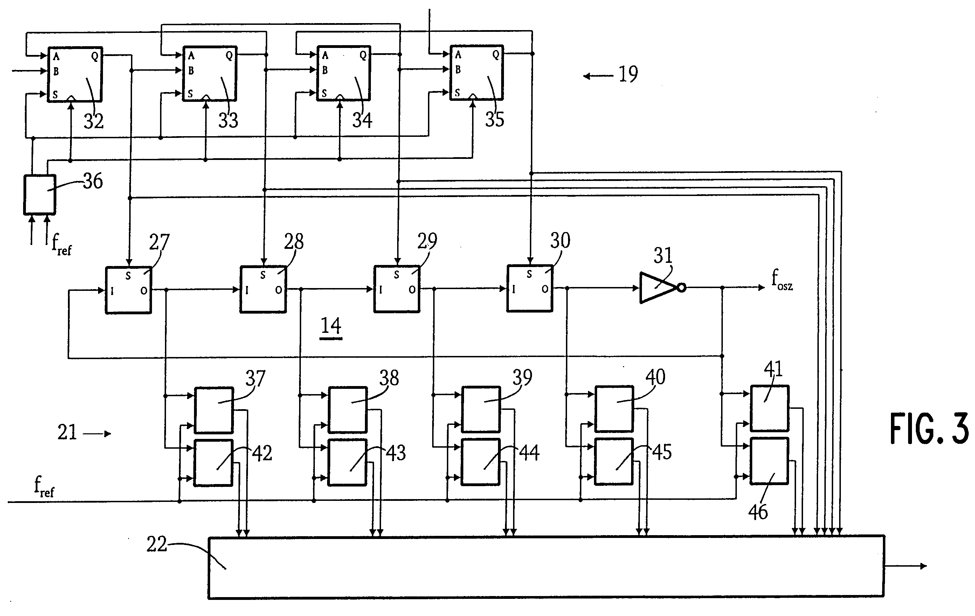

Der Phasenvergleicher 15 enthält eine Zähleranordnung 20, Kippgliedanordnungen 21, eine Auswerteschaltung 22, eine Kombinationsschaltung 23 und ein Register 24. Die Zähleranordnung 20 empfängt das Oszillatorsignal des Ringoszillaors 14 und zählt die Takte während eines Taktzyklus eines Referenztaktsignales mit der Frequenz $f_{ref}$. Die Frequenz $f_{ref}$ des Referenztaktsignales ist kleiner als die Frequenz $f_{osz}$ des Oszillatorsignals. Die während eines Taktzyklus des Referenztaktsignals gezählten Takte des Oszillatorsignals in der Zähleranordnung 20 werden als Zählergebnis einem ersten Addierer 25 der Kombinationsschaltung 23 zugeführt. Außerdem erhält der Addierer 25 noch Phasenwerte von der Auswerteschaltung 22, die mit dem Ausgang der Steueranordnung 19 und den Ausgängen der Kippgliedanordnungen 21 gekoppelt sind. Die Kippgliedanordnungen 21 sind jeweils mit in dem Ringoszillator 14 enthaltenen Verzögerungsgliedern verbunden. Wenn die Jitteranforderungen nicht hoch sind, sind die Kippgliedanordnungen 21 und die Auswerteschaltung 22 nicht erforderlich. Ein Ausführungsbeispiel für eine Steueranordnung 19, einen Ringoszillator 14, die Kippgliedanordnungen 21 und die Auswerteschaltung 22 ist in der Fig. 3 dargestellt und wird weiter unten erläutert.

Die Kombinationsschaltung 23 enthält noch einen weiteren Addierer 26, der das Additionsergebnis von Phasenwerten und Zählergebnissen des Addierers 25 empfängt. Ferner erhält der Addierer 26 noch den im Register 24 gespeicherten Sollphasenwert, der jeweils beispielsweise mit einer ansteigenden Flanke des Referenztaktsignals vom Tiefpaßfilter 11 übernommen wird. Die vom Addierer 26 bzw. der Kombinationsschaltung 23 gelieferten aufeinanderfolgenden Werte bilden das Vergleichssignal. Dieses Vergleichssignal wird über das Tiefpaßfilter 16, den Sigma-Delta-Modulator 17 und den Differenzierer 18 zur Steueranordnung 19 geführt. Der Sigma-Delta-Modulator 17 liefert ein Ausgangssignal, welches einen höherwertigen, einen mittleren und einen niederwertigen Zustand aufweist. Beispielsweise wird dies durch die Werte "1", "0" und "-1" dargestellt. Der Differenzierer 17 dient zur Kompensation des integrierenden Verhaltens der Auswerteschaltung 22. Der Ausgang der Steueranordnung 19 weist - wie oben erwähnt - eine Verbindung mit der Auswerteschaltung 22 und dem Ringoszillator 14 auf.

In der Fig. 3 ist ein Ausführungsbeispiel eines Ringoszillators 14 mit 5 Verzögerungsgliedern 27 bis 31 dargestellt. Die Verzögerungsglieder 27 bis 31 sind in Reihe geschaltet und der Ausgang des letzten Verzögerungsgliedes 31 ist mit dem Eingang des ersten Verzögerungsgliedes 27 verbunden. Das letzte Verzögerungsglied 31 liefert auch das Oszillatorsignal mit der Frequenz $f_{osz}$. Zur Einstellung der Frequenz des Ringoszillators 14 sind die Verzögerungszeiten der Verzögerungsglieder 27 bis 30 über die Steueranordnung 19 einstellbar. In der Steueranordnung 19 ist ein Schieberegister mit 4 Schiebeelementen 32 bis 35 enthalten. Jedem einstellbaren Verzögerungsglied 27 bis 30 ist ein Schiebeelement 32 bis 35 zugeordnet. Beispielsweise steuert das Schiebeelement 33 das Verzögerungsglied 28.

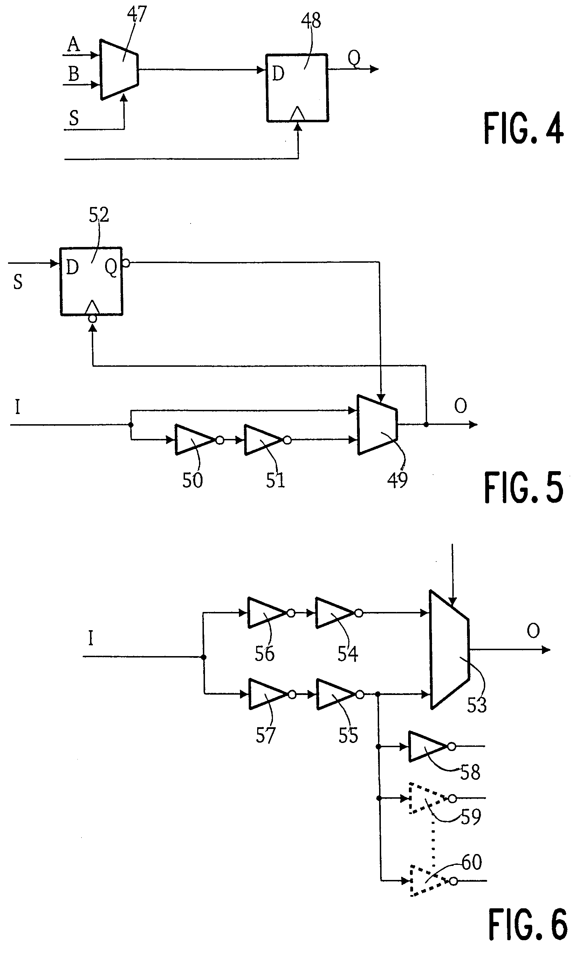

Ein Ausführungsbeispiel für ein Schiebeelement 32 bis 35 ist in der Fig. 4 aufgeführt. Ein Schiebeelement 32 bis 35 enthält einen ersten Umschalter 47 und ein erstes D-Kippglied 48. Der Umschalter 47 verbindet einen seiner Eingänge A oder B mit seinem Ausgang, der mit dem D-Eingang des Kippgliedes 48 verbunden ist. Der Steuereingang S des Umschalters 47 empfängt ein aus dem Ausgangssignal des Differenzierers 18 gebildetes Signal. Der Takteingang des D-Kippgliedes 48 empfängt ein Schiebetaktsignal, das beispielsweise aus dem Referenztaktsignal abgeleitet sein kann. Der Ausgang des D-Kippgliedes 48 ist auch der Ausgang Q eines Schiebeelementes 32 bis 35.

Der Eingang B des ersten Schiebeelementes 32 weist einen höherwertigen Zustand (logisch "1") und der Eingang A des letzten Schiebeelementes 35 des Schieberegisters einen niederwertigen Zustand (logisch "0") auf. Das bedeutet, daß dem Eingang B des Schiebeelementes 32 eine logische "1" und dem Eingang A des Schiebeelementes 35 eine logische "0" zugeführt wird. Ein Ausgang Q eines Schiebeelementes 32, 33 und 34 ist jeweils mit den Eingang B eines Schiebeelementes 33, 34 und 35 verbunden. Ferner ist ein Ausgang Q eines Schiebeelementes 35, 34 und 33 jeweils mit dem Eingang A eines Schiebeelementes 34, 33 und 32 verbunden. Den Steuereingängen und den Takteingängen der Schiebeelemente 32 bis 35 wird jeweils ein Steuersignal und ein Taktsignal von einem Decoder 36 zugeleitet, der das Ausgangssignal von dem Differenzierer 18 und das Referenztaktsignal erhält. Der Decoder 36 liefert bei einem höherwertigen Zustand (logisch "1") des Ausgangssignals des Differenzierers 18 ein Steuersignal, bei dem der erste Umschalter 47 jedes Schiebeelementes 32 bis 35 den Eingang A mit seinem Ausgang verbindet. Der erste Umschalter 47 jedes Schiebeelementes 32 bis 35 stellt eine Verbindung seines Ausgangs mit dem Eingang B her, wenn das Ausgangssignal des Differenzierers 18 einen niederwertigen Zustand (logisch "-1") aufweist. Bei einem mittleren Zustand (logisch "0") wird vom Decoder 36 das Referenztaktsignal nicht weitergeleitet, so daß sich der Inhalt der ersten Kippglieder 48 der Schiebeelemente 32 bis 35 nicht ändern kann.

Die Ausgangssignale der Schiebeelemente 32 bis 35 dienen zur Einstellung der Verzögerungszeit der zugeordneten Verzögerungsglieder 27 bis 30. Ist im D-Kippglied 48 des Schiebeelementes 32 ein höherwertiger Zustand abgespeichert, so ist im zugeordneten Verzögerungsglied 27 eine kurze Verzögerungszeit eingestellt. Im Verzögerungsglied 29 ist eine lange Verzögerungszeit eingestellt, wenn im D-Kippglied 48 des zugeordneten Schiebeelementes 34 ein niederwertiger Zustand vorliegt. Hieraus folgt, das bei diesen Zuständen der Schiebeelemente 32 bis 35 eine erste Gruppe von Schiebeelementen (32 und 33) zur Einstellung einer ersten, kurzen Verzögerungszeit und eine zweite Gruppe von Schiebeelementen (34 und 35) zur Einstellung einer zweiten, langen Verzögerungszeit vorgesehen sind. In Abhängigkeit vom Vergleichssignal des Phasenvergleichers 15, aus dem das Ausgangssignal des Sigma-Delta-Modulators abgeleitet ist, wird also der Anteil der Schiebeelemente 32 bis 35, die einer ersten oder zweiten Gruppe angehören gesteuert.

Mit dem Ausgang jedes Vezögerungsgliedes 27 bis 31 sind Kippgliedanordnungen 21 verbunden, die jeweils ein zweites Kippglied 37 bis 41 und jeweils ein drittes Kippglied 42 bis 46 enthalten. Die Kippglieder 37 bis 46 können RS-Kippglieder sein, die entweder von einer positiven Flanke oder einer negativen Flanke des die Verzögerungsglieder 27 bis 31 durchlaufenden Oszillatorsignals gesetzt werden. Die Kippglieder 37 bis 41 werden von den zugeordneten Verzögerungsgliedern 27 bis 31 jeweils durch eine positive Flanke des Oszillatorsignals und die Kippglieder 42 bis 46 werden von den zugeordneten Verzögerungsgliedern 27 bis 31 jeweils durch eine negative Flanke des Oszillatorsignals gesetzt. Zurückgesetzt werden die Kippglieder beispielsweise durch eine positive Flanke des Referenztaktsignals.

Die Auswerteschaltung 22 ermittelt zu einem Referenzzeitpunkt, beispielsweise bei Auftreten einer negativen Flanke des Referenztaktsignals, die Zustände der Kippglieder 37 bis 46. Somit kann festgestellt werden, bei welchem Verzögerungsglied 27 bis 31 zum Referenzzeitpunkt entweder eine positive oder negative Flanke des Oszillatorsignals vorliegt. Ferner erhält die Auswerteschaltung 22 noch die Ausgangssignale der Schiebeelemente 32 bis 35. Hieraus wird nach folgenden Formeln der Phasenwert $\Phi$, der von der Auswerteschaltung 22 geliefert wird, berechnet:

$$1)\quad x \leq n:$$

$$\Phi = 2\Pi \frac{x\ T_V}{2\ [N\ T_V + (N - n)\ \Delta T + T_i]} = \Phi_{P1}\ ,$$

wobei x die Anzahl der Kippglieder 37 bis 41 mit einer gespeicherten positiven Flanke des Oszillatorsignals, n die Anzahl der Verzögerungsglieder 27 bis 30 mit einer kleineren Verzögerungszeit ist, N die Gesamtzahl der Verzögerungsglieder, $T_V$ die kleinere Verzögerungszeit, $T_V + \Delta T$ die größere Verzögerungszeit und $T_i$ die Verzögerungszeit des als Inverter ausgebildeten Verzögerungsgliedes 31 ist;

$$x \leq n: \qquad\qquad\qquad 2)$$

$$\Phi = \Phi_{P1} + \Pi,$$

wobei x in diesem Fall die Anzahl der Kippglieder 42 bis 46 mit einer gespeicherten negativen Flanke des Oszillatorsignals ist;

$$3)\quad x > n:$$

$$\Phi = 2\Pi \frac{n\,T_V + (x - n)\,\Delta T}{2\,[N\,T_V + (N - n)\,\Delta T + T_i]} = \Phi_{P2}\,,$$

wobei x in diesem Fall die Anzahl der Kippglieder 37 bis 41 mit einer gespeicherten positiven Flanke des Oszillatorsignals ist;

$$x > n: \tag{4}$$

$$\Phi = \Phi_{P2} + \Pi,$$

wobei x in diesem Fall die Anzahl der Kippglieder 42 bis 46 mit einer gespeicherten negativen Flanke des Oszillatorsignals ist.

Die Auswerteschaltung 22, die beispielsweise eine Tabelle enthält, stellt also zuerst fest, ob eine negative oder positive Flanke gespeichert ist und berechnet dann anhand der Formeln den Phasenwert.

Im folgenden werden noch Ausführungsbeispiele für einstellbare Verzögerungsglieder 27 bis 30 erläutert. Das in Fig. 5 gezeigte Verzögerungsglied enthält einen zweiten Umschalter 49, zwei hintereinandergeschaltete Inverter 50 und 51 und eine Synchronisationsschaltung 52. Der Eingang I des Verzögerungsgliedes ist einerseits direkt und andererseits über die hintereinandergeschalteten Inverter 50 und 51 mit dem Umschalter 49 verbunden. Der Ausgang des Umschalters 49 ist auch der Ausgang des Verzögerungsgliedes. Das Signal zur Steuerung des Umschalters 49 wird über die Synchronisationsschaltung 52 dem Umschalter 49 geliefert. Die Synchronisationsschaltung 52 enthält ein D-Kippglied, dessen D-Eingang das Signal von einem Schiebeelement 32 bis 35 erhält und dessen invertierter Ausgang mit dem Steuereingang des Umschalters 49 verbunden ist. Der Takteingang des D-Kippgliedes erhält das invertierte Ausgangssignal des Umschalters 49. Mittels der Synchronisationsschaltung 52 werden Störimpulse verhindert. Der Umschalter 49 verbindet in Abhängigkeit vom über seinem Steuereingang empfangenen Signal entweder den Eingang direkt mit seinem Ausgang (erster Laufzeitweg) oder den Ausgang des zweiten Inverters 51 mit seinem Ausgang (zweiter Laufzeitweg).

In Fig. 6 ist ein Verzögerungsglied dargestellt, bei dem ein Umschalter 53 seinen Ausgang entweder mit einem ersten Inverter 54 oder zweiten Inverter 55 verbindet. Vor den beiden Invertern 54 und 55 sind noch jeweils Inverter 56 und 57 geschaltet. Der zweite Inverter 55 ist an seinem Ausgang mit mindestens einem weiteren Inverter 58 gekoppelt, der eine Ausgangsbelastung für den Inverter 55 darstellt. Der Ausgang des Inverters 58 ist offen. Hierdurch verändert sich die Verzögerungs- oder Laufzeit des Inverters 55. Diese wird dabei um einen kleineren Betrag als eine Inverterlaufzeit (Gatterlaufzeit) verändert.

Solche Verzögerungsmodule ermöglichen eine feinere Einstellung der Oszillatorfrequenz und -phase und somit eine weitere Verringerung des Jitters im zweiten vom Übertragungssystem gebildeten Signal. Die Ausgangsbelastung des Inverters 55 kann auch weiter durch Parallelschaltung eines oder mehrerer gestrichelt gezeichneter Inverter 59 bis 60 zum Inverter 58 erhöht werden.

**Patentansprüche**

1. Übertragungssystem mit einem Phasenregelkreis (12), der

- einen Phasenvergleicher (15) zum Vergleich eines Oszillatorsignals mit einem Referenzsignal und zur Erzeugung eines Vergleichssignals und
- einen Oszillator enthält, der zum Empfang eines aus dem Vergleichssignal abgeleiteten Steuersignals vorgesehen ist,

dadurch gekennzeichnet,
daß der als Ringoszillator (14) ausgebildete Oszillator wenigstens ein in einem Ring geschaltetes Verzögerungsglied (27 bis 31) enthält,
daß wenigstens ein Verzögerungsglied (27 bis 30) wenigstens zwei unterschiedliche einstellbare Verzögerungszeiten aufweist und

daß eine Steueranordnung (19) in Abhängigkeit vom Vergleichssignal zur Einstellung der Verzögerungszeiten von wenigstens einem Verzögerungsglied (27 bis 30) vorgesehen ist.

2. Übertragungssystem nach Anspruch 1,
dadurch gekennzeichnet,
daß die Steueranordnung (19) ein Schieberegister mit Schiebeelementen (32 bis 35) enthält, deren Anzahl der Anzahl der einstellbaren Verzögerungsglieder (27 bis 30) entspricht,
daß ein Schiebeelement (32 bis 35) zur Einstellung der Verzögerungszeit eines zugeordneten Verzögerungsgliedes (27 bis 30) vorgesehen ist und
daß in Abhängigkeit vom Vergleichssignal eine erste Gruppe von Schiebeelementen (32 bis 35) zur Einstellung einer ersten und/oder wenigstens eine zweite Gruppe von Schiebeelementen (32 bis 35) zur Einstellung einer zweiten Verzögerungszeit vorgesehen ist.

3. Übertragungssystem nach Anspruch 2,
dadurch gekennzeichnet,
daß ein Schiebeelement (32 bis 35) ein erstes Kippglied (48) und ein vor dem Eingang des ersten Kippgliedes (48) angeordneten, in Abhängigkeit vom Vergleichssignal gesteuerten, ersten Umschalter (47) mit einem ersten und zweiten Eingang enthält,
daß der erste und zweite Eingang eines ersten Umschalters (47) eines Schiebeelementes (32 bis 35) den ersten und zweiten Eingang des Schiebeelementes (32 bis 35) und der Ausgang des ersten Kippgliedes (48) des Schiebeelementes (32 bis 35) den Ausgang des Schiebeelementes (32 bis 35) darstellen,
daß ein erstes Schiebeelement (32) an seinem ersten Eingang einen ersten Zustand und ein letztes Schiebeelement (35) an seinem zweiten Eingang einen zweiten Zustand aufweist und
daß jeweils der Ausgang der anderen zwischen dem ersten und letzten Schiebeelement (32, 35) angeordneten Schiebeelemente (33 bis 34) mit dem ersten Eingang des einen benachbarten und mit dem zweiten Eingang des anderen benachbarten Schiebeelementes (32 bis 35) gekoppelt ist.

4. Übertragungssystem nach einem der Ansprüche 1 bis 3,
dadurch gekennzeichnet,
daß ein einstellbares Verzögerungsglied (27 bis 30) einen zweiten Umschalter (49, 53) enthält, der gesteuert von der Steueranordnung (19) zur Kopplung des Eingangs des Verzögerungsgliedes (27 bis 30) mit dessen Ausgang über wenigstens zwei unterschiedliche Laufzeitwege vorgesehen ist.

5. Übertragungssystem nach Anspruch 4,
dadurch gekennzeichnet,
daß ein Laufzeitweg wenigstens einen Inverter (55) enthält, dessen Verzögerungszeit über die Ausgangsbelastung (58 bis 60) einstellbar ist.

6. Übertragungssystem nach Anspruch 4 oder 5,
dadurch gekennzeichnet,
daß ein zweiter Umschalter (49, 53) eines einstellbaren Verzögerungsgliedes (27 bis 30) zum Empfang eines über eine Synchronisationsschaltung (52) eines Verzögerungsgliedes (27 bis 30) zugeführten Umschaltsignals von dem zugeordneten Schiebeelement vorgesehen ist und
daß die Synchronisationsschaltung (52) zur Synchronisation des Umschaltsignals mit dem Ausgangssignal des Verzögerungsgliedes (27 bis 30) vorgesehen ist.

7. Übertragungssystem nach einem der Ansprüche 1 bis 6,
dadurch gekennzeichnet,
daß der Phasenvergleicher (15)

- eine Zähleranordnung (20), die zur Zählung der Taktzyklen des Oszillatorsignals während eines Taktzyklus eines Referenztaktsignals vorgesehen ist, und
- eine Kombinationsschaltung (23) enthält, die zur Erzeugung des Vergleichssignals durch Kombination des Zählergebnisses und dem Sollphasenwert vorgesehen ist.

8. Übertragungssystem nach Anspruch 7,
dadurch gekennzeichnet,
daß der Phasenvergleicher (15) jeweils jedem Verzögerungsglied (27 bis 31) zugeordnete Kippgliedanordnungen (21) zur Speicherung des Ausgangszustandes des jeweiligen Verzögerungsgliedes (27 bis 31) zu von dem Referenztaktsignal gegebenen Referenzzeitpunkten enthält,
daß eine Auswerteschaltung (22) zur Ermittlung eines Phasenwertes zu einem Referenzzeitpunkt anhand der gespeicherten Ausgangszustände der Verzögerungsglieder (27 bis 31) und der eingestellten Verzögerungszeit eines Verzögerungsgliedes (27 bis 31) vorgesehen ist und daß die Kombinationsschaltung (23) zur Kombination des Phasenwertes mit dem Sollphasenwert und dem Zählergebnis vorgesehen ist.

9. Übertragungssystem nach Anspruch 8,
   dadurch gekennzeichnet,
   daß jede Kippgliedanordnung (21) ein zweites Kippglied (37 bis 40) zur Speicherung eines höherwertigen Ausgangszustandes und ein drittes Kippglied (42 bis 45) zur Speicherung eines niederwertigen Ausgangszustandes des zugeordneten Verzögerungsgliedes (27 bis 31) enthält.

10. Übertragungssystem nach Anspruch 9,
    dadurch gekennzeichnet,
    daß der Ringoszillator (14) eine gerade Anzahl von einstellbaren Verzögerungsgliedern (27 bis 30) und einen Inverter (31) als nicht einstellbares Verzögerungsglied enthält.

11. Übertragungssystem nach Anspruch 10,
    dadurch gekennzeichnet,
    daß die Auswerteschaltung (22) den Phasenwert $\Phi$ durch folgende Formel berechnet

$$\Phi = 2\Pi \frac{x \; T_v}{2 \; [N \; T_v + (N - n) \; \Delta T + T_i]} = \Phi_{P1} \; ,$$

wenn die Anzahl x der den höherwertigen Ausgangszustand speichernden Kippgliedanordnungen (21) kleiner oder gleich der Anzahl n der auf eine erste, kleiner als die zweite andauernde Verzögerungszeit eingestellten Verzögerungs glieder (27 bis 30) ist,
daß die Auswerteschaltung (22) den Phasenwert $\Phi$ durch folgende Formel berechnet

$$\Phi = \Phi_{P1} + \Pi,$$

wenn die Anzahl x der den niederwertigen Ausgangszustand speichernden Kippgliedanordnungen (21) kleiner oder gleich der Anzahl n der auf eine erste Verzögerungszeit eingestellten Verzögerungsglieder (27 bis 30) ist, daß die Auswerteschaltung (22) den Phasenwert $\Phi$ durch folgende Formel berechnet

$$\Phi = 2\Pi \frac{n \; T_v + (x - n) \; \Delta T}{2 \; [N \; T_v + (N - n) \; \Delta T + T_i]} = \Phi_{P2} \; ,$$

wenn die Anzahl x der den höherwertigen Ausgangszustand speichernden Kippgliedanordnungen (21) größer als die Anzahl n der auf eine erste Verzögerungszeit eingestellten Verzögerungsglieder (27 bis 30) ist, und
daß die Auswerteschaltung (22) den Phasenwert $\Phi$ durch folgende Formel berechnet

$$\Phi = \Phi_{P2} + \Pi,$$

wenn die Anzahl x der den niederwertigen Ausgangszustand speichernden Kippgliedanordnungen (21) größer als die Anzahl n der auf eine erste Verzögerungszeit eingestellten Verzögerungsglieder (27 bis 30) ist,
wobei N die Gesamtzahl der Verzögerungsglieder (27 bis 31), $T_v$ die erste Verzögerungszeit, $T_v + \Delta T$ die zweite Verzögerungszeit und $T_i$ die Verzögerungszeit des als Inverter (31) ausgebildeten Verzögerungsgliedes ist.

12. Übertragungssystem nach einem der Ansprüche 1 bis 11,
    dadurch gekennzeichnet,
    daß zwischen Phasenvergleicher (15) und Steueranordnung (19) ein Sigma-Delta-Modulator (17) zur Erzeugung eines Ausgangssignals angeordnet ist, welches drei unterschiedliche Zustände aufweisen kann.

**13.** Übertragungssystem nach Anspruch 3 und 12,
<u>dadurch gekennzeichnet</u>,
daß bei einem höherwertigen Zustand eines aus dem Ausgangssignal des Sigma-Delta-Modulators (17) abgeleitetes Signal ein erstes, in einem ersten Zustand befindliches Kippglied (48) zum Wechsel in einen zweiten Zustand,
bei einem niederwertigen Zustand des Signals ein erstes, in einem zweiten Zustand befindliches Kippglied (48) zum Wechsel in einen ersten Zustand und
bei einem mittleren Zustand des Signals kein erstes Kippglied (48) zur Änderung seines Zustandes vorgesehen ist.

**14.** Übertragungssystem nach einem der Ansprüche 1 bis 13,
<u>dadurch gekennzeichnet</u>, daß

- ein Pufferspeicher (6) zur Zwischenspeicherung von Daten eines ersten Signals mit einer ersten Bitrate und zur Bildung eines zweiten Signals mit einer zweiten Bitrate,
- ein Schreibadressengenerator (7) zum Empfang eines aus dem ersten Signal abgeleiteten Schreibtaktsignals und zur Lieferung von Schreibadressen,
- ein Leseadressengenerator (9) zum Empfang eines aus dem Oszillatorsignal des Phasenregelkreises (12) abgeleiteten Lesetaktsignals und zur Lieferung von Leseadressen,
- ein Subtrahierer (10) zur Subtraktion der von dem Lese- und Schreibadressengenerator (7, 9) gebildeten Lese- und Schreibadressen und zur Lieferung eines Differenzsignals und
- der Phasenregelkreis (12) zum Empfang der aus dem Differenzsignal abgeleiteten Sollphasenwerte vorgesehen ist.

**15.** Phasenregelkreis (12) mit

- einen Phasenvergleicher (15) zum Vergleich eines Oszillatorsignals mit einem Referenzsignal und zur Erzeugung eines Vergleichssignals und
- einen Oszillator, der zum Empfang eines aus dem Vergleichssignal abgeleiteten Differenzsignals vorgesehen ist,

<u>dadurch gekennzeichnet</u>,
daß der als Ringoszillator (14) ausgebildete Oszillator wenigstens ein in einem Ring geschaltetes Verzögerungsglied (27 bis 31) enthält,
daß wenigstens ein Verzögerungsglied (27 bis 30) wenigstens zwei unterschiedliche einstellbare Verzögerungszeiten aufweist und
daß eine Steueranordnung (19) in Abhängigkeit vom Vergleichssignal zur Einstellung der Verzögerungszeiten von wenigstens einem Verzögerungsglied (27 bis 30) vorgesehen ist.

FIG. 1

FIG. 2

FIG. 3

FIG. 4

FIG. 5

FIG. 6